(19) **Europäisches Patentamt / European Patent Office / Office européen des brevets**

(11) **EP 1 786 104 B1**

(12) **FASCICULE DE BREVET EUROPEEN**

(45) Date de publication et mention
de la délivrance du brevet:
**11.01.2012 Bulletin 2012/02**

(21) Numéro de dépôt: **06123660.0**

(22) Date de dépôt: **08.11.2006**

(51) Int Cl.:
*H03K 5/15* (2006.01)          *H03K 5/13* (2006.01)
*H01S 3/23* (2006.01)          *G21B 1/11* (2006.01)

(54) **Dispositif de génération de signaux de synchronisation à très faible gigue**

Anordnung zum Generieren von Synkronisiersignalen mit sehr niedrigem Jitter

Device for generating synchronising signals with very low jitter.

(84) Etats contractants désignés:
**AT BE BG CH CY CZ DE DK EE ES FI FR GB GR
HU IE IS IT LI LT LU LV MC NL PL PT RO SE SI
SK TR**

(30) Priorité: **15.11.2005 FR 0553472**

(43) Date de publication de la demande:
**16.05.2007 Bulletin 2007/20**

(73) Titulaire: **Commissariat à l'Énergie Atomique
et aux Énergies Alternatives
75015 Paris (FR)**

(72) Inventeurs:
• **Pastor, Jean-François
77600 Guermantes (FR)**
• **Prat, Michel
91290 Arpajon (FR)**

(74) Mandataire: **Augarde, Eric et al
BREVALEX
95 rue d'Amsterdam
75378 Paris Cedex 8 (FR)**

(56) Documents cités:
**US-A- 4 885 557          US-A1- 2003 193 360
US-A1- 2005 030 079          US-A1- 2005 179 479**

• **SHUE C-W ED - INSTITUTE OF ELECTRICAL AND
ELECTRONICS ENGINEERS: "CLOCK SIGNAL
DISTRIBUTION NETWORK FOR HIGH SPEED
TESTERS" MEETING THE TESTS OF TIME.
WASHINGTON, AUG. 29 - 31, 1989,
PROCEEDINGS OF THE INTERNATIONAL TEST
CONFERENCE, WASHINGTON, IEEE COMP.
SOC. PRESS, US, vol. CONF. 20, 29 août 1989
(1989-08-29), pages 199-207, XP000089948 ISBN:
0-8186-8962-5**

**Description**

**DOMAINE TECHNIQUE**

L'invention concerne un dispositif de génération de signaux de synchronisation à très faible gigue.

L'invention s'applique en particulier à la synchronisation du déclenchement d'impulsions laser dans un système de fusion thermonucléaire par confinement inertiel.

Classiquement, dans un tel système, une cible, sous forme de microbille comprenant un mélange de deutérium et de tritium, est soumise à l'irradiation conjointe et simultanée d'un nombre élevé de faisceaux lasers pendant un laps de temps très court. Sous l'effet de cette irradiation, les couches superficielles sont consommées par ablation et le matériau de la bille transformé en plasma à haute température. La volatilisation des couches superficielles, génère selon le principe de la conservation de la quantité de mouvement, une onde de choc centripète qui vient confiner violemment le plasma. Le processus de fusion thermonucléaire prend naissance lorsque le produit du temps de confinement par température atteint une valeur de seuil (loi de Lawson).

**ÉTAT DE LA TECHNIQUE ANTÉRIEURE**

Le projet américain NIF (National Ignition Facility), dont on trouvera une description dans la revue ICF Quaterly report, Vol. 9, No. 1, Oct.-Dec. 1998, ainsi que le projet français LMJ (Laser Méga Joule) prévoient un grand nombre faisceaux (192 dans le système NIF, 240 dans le système LMJ) convergents vers une cible D-T capables de délivrer ensemble une puissance de près de 2 MJ pendant un durée de 10-20 ns.

Une condition critique du confinement inertiel est l'arrivée simultanée des fronts d'onde sur la cible laser. Ceci est d'autant plus vrai que pour obtenir un gain énergétique élevé (rapport en énergie thermonucléaire dégagée sur énergie lumineuse injectée) on est amené à n'allumer que le centre de la microbille (principe d'allumage par point chaud central). La simultanéité d'arrivée des impulsions lasers sur la microbille est également nécessaire pour obtenir un confinement isotrope, tout défaut de simultanéité se traduisant par une perte de sphéricité du point chaud.

Pour donner un ordre de grandeur de la contrainte de simultanéité, le cahier des charges du système NIF indique une tolérance maximale de 12 ps.

Cette contrainte de simultanéité suppose que l'on sache fournir aux lasers d'injection des signaux de synchronisation avec une précision et une stabilité temporelles élevées.

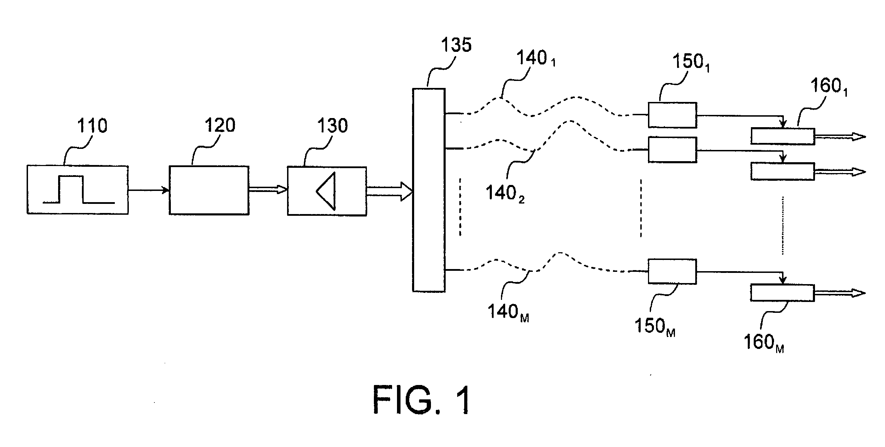

Un dispositif de génération de tels signaux de synchronisation est connu du document précité et est illustré en Fig. 1. Un générateur d'impulsions électriques 110 fournit une impulsion de durée 100ps à un modulateur électro-optique 120. L'impulsion optique correspondante est ensuite amplifiée par passage dans un amplificateur 130 constitué d'une série de fibres pompées avant d'être divisée au moyen d'un diviseur optique 135 connecté à une pluralité de fibres $140_1,..,140_M$, jouant le rôle de lignes à retard. Les impulsions optiques issues de ces fibres sont transformées en impulsions électriques par des photodétecteurs $150_1,...,150_M$, les signaux de sortie de ces photodétecteurs pilotant ensuite les différents ensembles de génération d'impulsion laser $160_1,...,160_M$.

Ce dispositif présente cependant un certain nombre de limitations dues aux disparités et aux fluctuations des temps de réponse des photodétecteurs PD.

A supposer même que l'on puisse compenser en moyenne les disparités de temps de réponse de ces photodétecteurs, les fluctuations temporelles introduisent une gigue relative des signaux de synchronisation, préjudiciable à la condition de simultanéité précédemment évoquée. On appellera gigue relative de deux signaux la fluctuation de leur écart temporel.

Plus précisément, si les deux signaux de synchronisation s'expriment sous la forme de fonctions aléatoires :

$$S_1(t) = S(t_0+t-\tau_1-g_1(\tau_1))$$

$$S_2(t) = S(t_0+t-\tau_2-g_2(\tau_2))$$

où $t_0$ est un instant de référence, $S(t)$ un signal déterministe ayant servi à générer les signaux de synchronisation, $\tau_1$, $\tau_2$ sont les retards affectant respectivement les deux signaux par rapport à l'instant de référence et $g_1(\tau_1)$, $g_2(\tau_2)$ des variables aléatoires représentant les gigues respectives des deux signaux. On appellera gigue relative des signaux de synchronisation, la variable aléatoire $g_{21}=g_2(\tau_2)-g1(\tau_1)$. Cette variable aléatoire $g_{21}$ est de moyenne nulle comme $g_1(\tau_1)$ et $g_2(\tau_2)$ et de variance $\sigma_{12}$. La valeur $\sigma_{12}$ donne une mesure de la valeur quadratique moyenne de la gigue et aussi dénommée gigue RMS (root-mean-square). Par commodité de langage nous l'appellerons également « gigue », l'ambiguïté étant levée par le contexte.

Généralement la densité de probabilité de la variable aléatoire $g_{21}$ est gaussienne et s'exprime alors sous la forme :

$$p(g_{21} = g) = \frac{1}{\sqrt{2\pi\sigma_{12}^2}} \exp(-\frac{g^2}{\sigma_{12}^2})$$

Un but de la présente invention est de prévoir un dispositif de génération de signaux de synchronisation à très faible gigue, au sens défini plus haut, notamment pour la synchronisation du déclenchement d'impulsions laser dans un système de fusion thermonucléaire par confinement inertiel.

## EXPOSÉ DE L'INVENTION

A cette fin l'invention est définie par un dispositif de génération de signaux de synchronisation à très faible gigue
selon la revendication 1.
Avantageusement, les éléments électriques passifs sont des lignes coaxiales adaptées.

## BRÈVE DESCRIPTION DES DESSINS

L'invention sera mieux comprise par la description de modes de réalisation à l'aide des figures suivantes :

- la Fig. 1 illustre un système de génération de signaux de synchronisation connu de l'état de la technique ;
- la Fig. 2 illustre un système de génération de signaux de synchronisation connu de l'état de la technique;
- la Fig. 3 illustre un système de génération de signaux de synchronisation selon un premier mode de réalisation de l'invention ;
- la Fig. 4 illustre un élément électrique actif permettant de générer un retard de grande précision.

## EXPOSÉ DÉTAILLÉ DE MODES DE RÉALISATION PARTICULIERS

L'idée à la base de l'invention est de s'affranchir des conversions électro-optique et opto-électrique pénalisantes en termes de gigue. Pour ce faire, il est proposé de générer les signaux de synchronisation à partir d'un signal électrique unique ou signal maître, retardé à travers un ensemble de retards répartis de manière arborescente, les retards étant constitués par des éléments électriques passifs.

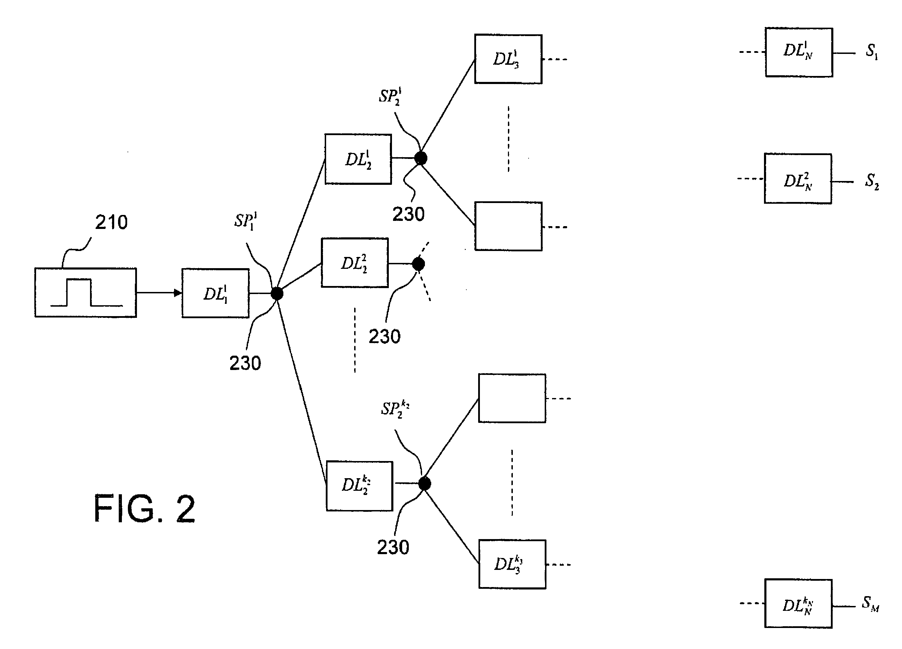

La Fig. 2 illustre un tel système. Le générateur 210 produit un signal électrique maître dont seront issus les signaux de synchronisation. Ce signal est préférentiellement une impulsion de forte amplitude mais peut également, par exemple, prendre la forme d'un échelon montant. De manière générale, il suffira que ce signal contienne un motif susceptible, soit directement soit indirectement au moyen d'un traitement approprié, linéaire (par exemple dérivation) ou non linéaire (par exemple seuillage), de définir précisément un temps de référence.

Ce signal électrique, après amplification éventuelle, est ensuite retardé par un jeu de retards $DL_1^1 \; ; \; DL_2^1, \ldots DL_2^{k_2} \; ; \; DL_3^1, \ldots DL_3^{k_3} \; ; \ldots \; ; \; DL_N^1, \ldots DL_N^{k_N}$ organisés selon un arbre dont les noeuds 230 sont constitués de diviseurs : le signal retardé par le retard de premier rang $DL_1^1$ est injecté au moyen du diviseur $SP_1^1$ dans $k_2$ retards de second rang $DL_2^1, \ldots DL_2^{k_2}$, les signaux issus de ces retards étant eux-mêmes divisés et ainsi de suite. Les signaux issus des $k_N$ retards de dernier rang N, soit $DL_N^1, \ldots DL_N^{k_N}$, forment les différentes voies de synchronisation.

L'arbre peut être d'ordre 2 (chaque noeud alimentant alors deux branches), auquel cas les diviseurs peuvent être constitués de coupleurs 6 dB, ou d'ordre supérieur. Le nombre de branches alimentées par un noeud peut varier d'un noeud à l'autre. Les diviseurs ne présentent pas nécessairement un gain identique sur les différents ports de sortie, ceci afin de tenir compte par exemple des tailles différentes des sous-arbres connectés à ces ports, ou pour équilibrer les gains des signaux de synchronisation.

Les retards sont constitués d'éléments électriques passifs, c'est-à-dire non alimentés par une source d'énergie électrique et par conséquent possédant des caractéristiques non tributaires de variations de tension ou de courant d'une telle source.

Les retards passifs seront par exemple constitués de lignes de propagation. On peut montrer mathématiquement de manière simple, en utilisant la loi des grands nombres, que la gigue en sortie d'une ligne de propagation présente une distribution de probabilité gaussienne. La variance (gigue RMS) sera d'autant plus élevée que la ligne de propagation est longue, la loi de variation étant théoriquement linéaire.

Le document Hsue, E.W.: "Clock signal distribution network for high speed testers", Proceedings of the international test conference, Washington, IEEE, vol. 20, p.199-207, 29.08.1989 divulgue un tel circuit.

De manière préférentielle, les retards passifs seront réalisés au moyen de lignes coaxiales. Outre le fait que les lignes coaxiales présentent une bonne immunité contre le bruit et la diaphonie, elles possèdent la propriété remarquable de ne pas générer de gigue, et ce, même sur des longueurs importantes. A titre d'exemple, une ligne coaxiale de 200m possède une gigue non détectable par les appareils de mesure actuels, et par conséquent largement inférieure à 5 ps.

Les lignes coaxiales sont avantageusement adaptées, par exemple à une impédance caractéristique de 50Ω.

Il est néanmoins difficile de réaliser des retards avec un haut degré de résolution au moyen de lignes coaxiales. En pratique, une résolution de longueur de 5mm à 10mm peut être obtenue, soit une résolution temporelle de l'ordre de 25ps. De manière plus générale, il s'avère délicat de réaliser des retards passifs présentant une résolution temporelle élevée.

Selon un premier mode de réalisation de l'invention, la résolution des retards est accrue au prix d'une légère perte de performance en termes de gigue relative. Pour ce faire, le système de synchronisation comprend, outre un arbre de retards passifs, avantageusement réalisés par des lignes coaxiales, un second type de retards, réglables, avantageusement placés dans les branches extrémales, c'est-à-dire les branches se terminant par une extrémité de l'arbre.

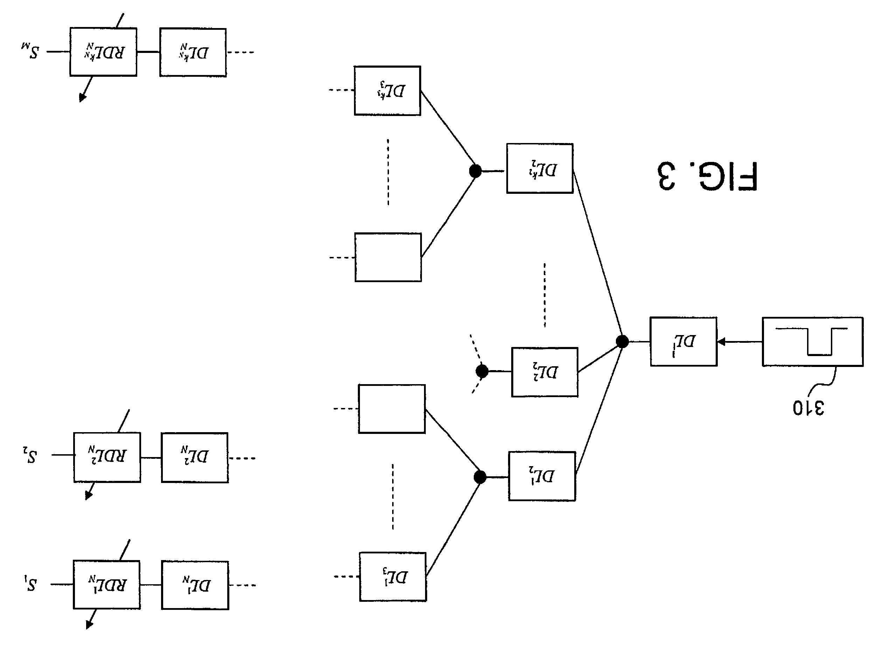

La Fig. 3 illustre le premier mode de réalisation dans lequel les éléments identiques à ceux de la Fig. 2 sont notés de manière identique. Les retards de second type, notés $RDL_N^1 , \ldots RDL_N^{k_N}$ sont présents dans les branches extrémales, en série avec les retards de premier type $DL_N^1 , \ldots DL_N^{k_N}$. Le signal maître généré par le générateur 310 est retardé dans l'arbre des retards du premier type puis par les retards réglables $RDL_N^1 , \ldots RDL_N^{k_N}$.

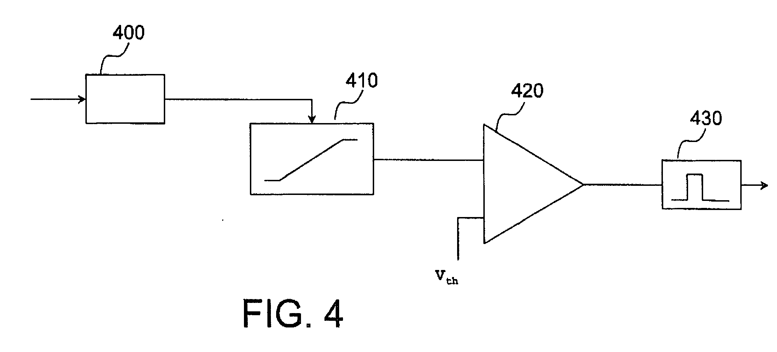

Les retards $RDL_N^1 , \ldots RDL_N^{k_N}$ sont susceptibles de réglage fin, avec une résolution plus fine que celle d'obtention des retards du premier type. Un exemple de retard de second type selon l'invention est illustré schématiquement en Fig. 4. Il est constitué d'un circuit électronique actif comprenant un détecteur d'impulsion 400, un générateur de rampe de tension à haute précision 410, un comparateur de tension 420 et un générateur d'impulsion 430. Lorsqu'une impulsion entrante est détectée par le détecteur d'impulsion 400, un premier signal de déclenchement est transmis au générateur de rampe. La tension en sortie de ce dernier est comparée à une tension de seuil $V_{th}$ au moyen du comparateur 420. Le comparateur peut être réalisé à partir d'un amplificateur opérationnel, un miroir de courant ou tout système analogue bien connu de l'homme du métier. Lorsque la tension de rampe atteint la tension de seuil, un second signal de déclenchement est transmis au générateur d'impulsion 430. Le générateur de rampe peut être constitué d'un intégrateur à très faible pente. Le réglage se fait par exemple en modifiant la tension de seuil. Ce type de dispositif permet d'atteindre une résolution de retard de l'ordre de 2 à 3 ps.

Supposons maintenant que l'on souhaite réaliser un retard de valeur donnée $\Delta T$ et que l'on dispose d'un ensemble de $N$ retards du premier type, soit $N$ valeurs discrètes croissantes $\Delta t_0, \Delta t_1, \Delta t_2, \ldots, \Delta t_{N-1}$. On choisira avantageusement une série géométrique de raison 2, à savoir $\Delta t_{N-1} = 2\Delta t_{N-2} \ldots = 2\Delta t_1 = 2\Delta t_0$. Pour $\Delta t \leq (2^N-1)\Delta t_0$ il sera alors possible de trouver des valeurs binaires $a_0, a_1, \ldots, a_{N-1}$ telles que $a_0 \Delta t_0 + a_1 \Delta t_1 + \ldots + a_{N-1} \Delta t_{N-1}$ approche $\Delta T$ à mieux que $\Delta t_0/2$ près. Le retard $\Delta T$ sera réalisé par la mise en série des retards discrets $\Delta t_i$ pour lesquels $a_i = 1$.

En utilisant un retard à réglage fin et de faible excursion (toutefois supérieure ou égale à $\Delta t_0/2$), en série avec lesdits retards discrets, il est alors possible d'approcher $\Delta T$ à $\delta t$ près, où $\delta t$ est la résolution de retard $\delta t \ll \Delta t_0/2$.

L'insertion de ces retards se fait cependant au prix d'une augmentation de gigue relative. En effet, soit deux signaux de synchronisation $S_p, S_q$ leur gigue relative s'écrit bien entendu : $g_{pq} + r_{pq}$ où $g_{pq}$ est la gigue relative introduite par les retards du premier type et $r_{pq}$ est la gigue relative introduite par les retards du second type. $g_{pq}$ et $r_{pq}$ étant des variables aléatoires indépendantes, si l'on note $\gamma_{pq}$ et $\rho_{pq}$ leurs densités de probabilité respectives, $g_{pq} + r_{pq}$ possède une densité de probabilité $\gamma_{pq} \otimes \rho_{pq}$ et donc de variance plus élevée que la variance $\sigma_{pq}$ de $g_{pq}$.

Si l'on souhaite disposer d'un réglage indépendant des signaux de synchronisation, les retards du second type ne seront placés que dans les branches extrémales, c'est-à-dire dans les branches connectées aux extrémités de l'arbre. L'ajout d'un retard du second type, non partagé par toutes les voies de synchronisation, ajouterait une gigue supplémentaire à celle déjà évoquée. *A contrario,* si l'on se contente d'un réglage commun à une pluralité de signaux de synchronisation, un retard de second type réglable sera placé à la racine du plus petit sous-arbre les délivrant.

Il convient de noter que les variations de retards dues aux variations de température peuvent être automatiquement compensées au moyen d'un ou de retard(s) de second type, commandé(s) par un ou des capteur(s) en température. Cette compensation sera d'autant plus aisée que la variation de retard induite par la variation de température d'une ligne coaxiale est essentiellement déterministe.

Les signaux de synchronisation à faible gigue générés par le système selon l'invention peuvent être utilisés pour le déclenchement d'impulsions laser ou servir de référence temporelle (marqueur temporel) à des appareils de mesure. De manière plus générale, le système de synchronisation selon l'invention permet de distribuer une information temporelle précise à des systèmes distants tout en étant particulièrement robuste. A ce titre, elle trouve également application à la synchronisation de systèmes synchrones répartis, notamment dans les réseaux de télécommunications.

Le système décrit peut prendre en charge l'intégralité de la fonction de synchronisation ou être intégré dans un système de synchronisation déjà existant.

## Revendications

1. Dispositif de génération de signaux de synchronisation à très faible gigue, notamment pour la synchronisation du déclenchement d'impulsions laser dans un système de fusion thermonucléaire à confinement inertiel, comprenant :

   - un générateur (310) de signal électrique maître,
   - une pluralité de premiers retards (DL) réalisés sous forme d'éléments électriques passifs, lesdits premiers retards étant organisés selon une structure d'arbre, les noeuds dudit arbre comportant des diviseurs de signal, ledit arbre étant alimenté à sa racine par le signal électrique maître et délivrant à ses extrémités lesdits signaux de synchronisation, **caractérisé en ce qu'**il comprend en outre :
   - des seconds retards réglables (RDL), réalisés sous forme d'éléments électriques actifs, lesdits seconds retards étant disposés en série avec lesdits premiers retards et présentant une résolution temporelle plus fine que la résolution temporelle de ceux-ci;

   chaque circuit actif (RDL) comprenant un détecteur d'impulsion (400), un générateur de rampe de tension (410), un comparateur de tension (420) par rapport à une tension de seuil (Vth) et un générateur d'impulsion (430), arranges en série.

2. Dispositif selon la revendication 1, **caractérisé en ce que** les éléments électriques passifs (DL) sont des lignes coaxiales adaptées.

3. Dispositif selon la revendication 1 ou 2, **caractérisé en ce que** les valeurs desdits premiers retards (DL) appartiennent à une série géométrique de raison 2.

4. Dispositif selon l'une des revendications précédentes, **caractérisé en ce que** lesdits seconds retards (RDL) sont placés dans les branches extrémales de l'arbre.

## Claims

1. Very low jitter synchronising signal generator device, in particular for the synchronisation of the triggering of laser pulses in an inertial confinement thermonuclear fusion system, comprising:

   - a master electrical signal generator (310),
   - a plurality of first delays (DL) in the form of passive electrical elements, said first delays being organised according to a tree structure, the nodes of said tree comprising signal dividers, said tree being fed at its root by the master electrical signal and delivering said synchronising signals to its ends,

   **characterised in that** it further comprises:

   - second adjustable delays (RDL) in the form of active electrical elements, said second delays being disposed in series with said first delays and having a time resolution finer than the time resolution of the first delays;

each active circuit (RDL) comprising a pulse detector (400), a voltage ramp generator (410), a voltage comparator (420) for comparing a voltage to a threshold voltage (Vth) and a pulse generator (430), arranged in series.

2. Device according to claim 1, **characterised in that** the passive electrical elements (DL) are adapted coaxial lines.

3. Device according to claim 1 or claim 2, **characterised in that** the values of said first delays (DL) belong to a geometric series with common ratio 2.

4. Device according to any one of the preceding claims, **characterised in that** said second delays (RDL) are placed in the end branches of the tree.

**Patentansprüche**

1. Vorrichtung zur Erzeugung von Synchronisationssignalen mit sehr schwachem Jitter, insbesondere für die Synchronisation der Auslösung von Laserpulsen in einem System zur thermonuklearen Fusion mit Trägheitseinschluß, umfassend:

- einen Generator (310) für ein elektrisches Hauptsignal,
- eine Mehrzahl von ersten Verzögerungen (DL), die in Form passiver elektrischer Elemente realisiert sind, wobei die ersten Verzögerungen gemäß einer Baumstruktur organisiert sind, wobei die Knoten des Baums Signalteiler umfassen, wobei der Baum an seiner Wurzel mit dem elektrischen Hauptsignal versorgt wird und an seinen Enden die Synchronisationssignale liefert,

**dadurch gekennzeichnet, dass** sie ferner umfaßt:

- zweite regelbare Verzögerungen (RDL), die in Form aktiver elektrischer Elemente realisiert sind, wobei die zweiten Verzögerungen in Reihe mit den ersten Verzögerungen angeordnet sind und eine zeitliche Auflösung aufweisen, die feiner als deren zeitliche Auflösung ist;

wobei jede aktive Schaltung (RDL) einen Pulsdetektor (400) umfaßt, einen Spannungsrampengenerator (410), einen auf eine Schwellenspannung (Vth) bezogenen Spannungskomparator (420) sowie einen Pulsgenerator (430), die in Reihe angeordnet sind.

2. Vorrichtung nach Anspruch 1, **dadurch gekennzeichnet, dass** die passiven elektrischen Elemente (DL) abgestimmte Koaxialleitungen sind.

3. Vorrichtung nach Anspruch 1 oder 2, **dadurch gekennzeichnet, dass** die Werte der ersten Verzögerungen (DL) zu einer geometrischen Reihe mit dem Verhältnis 2 gehören.

4. Vorrichtung nach einem der vorhergehenden Ansprüche, **dadurch gekennzeichnet, dass** die zweiten Verzögerungen (RDL) in den Endzweigen des Baums angeordnet sind.

FIG. 1

FIG. 2

FIG. 3

FIG. 4

**RÉFÉRENCES CITÉES DANS LA DESCRIPTION**

**Littérature non-brevet citée dans la description**

- *ICF Quaterly report,* Octobre 1998, vol. 9 (1